# EUROPEAN PATENT APPLICATION

(11) **EP 4 629 793 A1**
(43) Date of publication of application: **08.10.2025**
(21) Application number: 24168152.7
(22) Date of filing: 02.04.2024
(51) Int. Cl.: H10K 30/40, H10K 30/86

(54) **PEROVSKITE SOLAR CELL, ITS HOLE TRANSPORT LAYER AND SOLUTION FOR FORMING THE LAYER AND A RELATED USE OF AN ORGANOBORANE, A PREPARATION FOR AND A SOLAR MODULE WITH THE SOLAR CELL**

(71) Applicant: TOYOTA JIDOSHA KABUSHIKI KAISHA, Aichi-ken 471-8571 (JP)
(72) Inventor: KINGE, Sachin, 1140 Brussels (BE); DING, Yong, 1015 Lausanne (CH); DING, Bing, 1015 Lausanne (CH); NAZEERUDDIN, Mohammad Khaja, 1015 Lausanne (CH); DYSON, Paul Joseph, 1015 Lausanne (CH)
(74) Representative: Cabinet Beau de Loménie

(57) **Abstract**

An hole transport layer comprises a spiro compound, a dopant adjusting a state of the spiro compound, a polymer component comprising a polymer side group, and ion pairs are formed of the spiro compound and the polymer side group, the dopant comprising a Lewis acid being an organoborane.

## Description

### BACKGROUND OF THE INVENTION

### 1. Field of the Invention

The invention relates to a perovskite solar cell, its hole transport layer, its preparation method and a solar module with the perovskite solar cell. The invention also relates to a use of an organoborane as a Lewis acid dopant and to a solution with the organoborane and for forming the hole transport layer.

### 2. Description of Related Art

Perovskite solar cells (PSCs) formed with a perovskite layer between an electrode transport layer and a hole transport layer have rapidly developed to become one of the most promising photovoltaic technologies over the last decade, achieving the power conversion efficiency (PCE) like 26%. Perovskite solar cells based on organic semiconductors are described e.g. in
- Zhang et al., 2022 - Zhang et al., "Ion-modulated radical doping of spiro-OMeTAD for more efficient and stable perovskite solar cells", Science, 28 July 2022, Vol 377, Issue 6605 pp. 495-501 (DOI: 10.1126/science.abo2757), and
- You et al., 2023 - You et al., "Bifunctional hole-shuttle molecule for improved interfacial energy level alignment and defect passivation in perovskite solar cells", Nature Energy, 8, pp. 515-525, 2023 (https://doi.org/10.1038/s41560-023-01249-0).

As a base material for forming a hole transport layer of a perovskite solar cell is a polymer component, e.g. from the product PEDOT:PSS is known which combines Poly(3,4-ethylenedioxythiophene) and polystyrene sulfonate. The product is available e.g. from Xi'an Polymer Light Technology Corp. in Xi'an, China or under the trademark CLEVIOS from Heraeus Epurio GmbH, CHEMPARK Leverkusen, 51368 Leverkusen, Germany. It is supposed to provide stability of a hole transport layer in a perovskite solar cell, specifically regularly structured n-i-p type cells. Other known polymers for such a polymer component suitable as a base material for forming the hole transport layer are poly[bis(4-phenyl)(2,4,6-triMethylphenyl)amine] (PTAA) and poly(3-hexylthiophene) (P3HT). These polymer components include a conductive polymer like a thiophene-based polymer. A hole transport layer of a perovskite solar cell further includes a spiro compound as a charge transfer agent. According to Zhang et al., 2022 and You et al., 2023, a 9,9' - spirobifluorene, specifically, 2,2',7,7' -tetra-kis [N, N-di(4-methoxyphenyl)amino]-9,9'-spirobifluorene (spiro-OMeTAD) is used. Furthermore dopants are typically added to the hole transport layer like bis(trifluoromethane)sulfonimide lithium salt (Li-TFSI), tris(2-(1H-pyrazol-1-yl)pyridine) cobalt(III) (FK102) and 4-tert-butylpyridine (t-BP). Hygroscopic dopants are conventionally used which are sensitive to the environment, leading to a significant degradation of the photovoltaic performance. Further p-type additives were developed to promote the oxidation efficiency and stability of spiro-OMeTAD, like tetracyanoquinodimethane derivatives, ionic liquids, metal-TFSI complexes, and Lewis acid-Lewis base additives, with an aim to improve resistance to the environment and suppress degradation of the photovoltaic performance, in particular to adjust an oxidized state of spiro-OMeTAD in which spiro-OMeTAD forms a radical.

A perovskite layer of a perovskite solar cell typically includes Pb²⁺ ions together with iodine counter ions, in particular on the surface for passivation or compensating surface defects. However, radicals from the hole transport layer may react with iodine in a perovskite solar cell. Thus, the charge transfer agent in the hole transport layer may degrade to be its neutral state and p-doped property may be reduced. Accordingly rapid decrease in hole conductivity and the mismatching of interfacial energy level alignment at the interface between the hole transport layer and the perovskite layer, reducing the PCE is observed with conventional perovskite solar cells. Generally, it is desirable to avoid reducing the PCE with resistance against thermal and light-irradiation stresses and particularly with a water/oxygen barrier to protect lead ions on the perovskite surface so that the perovskite also maintains the alpha-phase under the environmental stresses. As countermeasure against such a degradation You et al., 2023, a iodide blocking barriers of (4-(3,6-bis(4-(bis(4-methoxyphenyl)amino)phenyl)-9H-carbazol-9-yl) benzenaminium iodide at the interface. This concept shows difficulty in balancing reduced layer thickness, thin enough to ensure the efficient hole transport, and sufficient layer thickness against iodide invasion into the hole transport layer.

Zhang et al., 2022 investigates doping modifications for a hole transport layer of a perovskite solar cell with the addition of salts from 4-tert.-butyl-1-methylpyridinium (TBMP⁺), ehtyldimethylpropylammonium (EDMPA⁺), 3-methyl-1-propylpyridinium (PMPIM⁺), or 1-propyl-3-methyl-imidazolinium (BMIM⁺) as a cation, and bis(trifluoromethylsulfonyl)imide (TFSI), BF₄⁻, or PF6 as an anion.

### SUMMARY OF THE INVENTION

It is an object of the invention to allow a superior combination of durability and performance of a perovskite solar cell. It is an object of the invention to provide a hole transport layer which efficiently contributes to long-term performance of a perovskite solar cell. This should be particularly allowed with an efficient production. This should be preferably allowed with a production with a moderate load on the environment. It is an object of the invention to provide doping concept for the hole transport layer.

An aspect of the invention is a use of an organoborane as a Lewis acid dopant for adjusting a state of a spiro compound in an hole transport layer, which is a layer for a perovskite solar cell (in particular an organic hole transport layer for interacting with a perovskite layer of the perovskite solar cell) and comprises the spiro compound, a polymer component comprising a polymer side group, and ion pairs formed of the spiro compound and the polymer side group. A solution according to the intention comprises an organic, in particular a non-polar, solvent, a spiro compound for forming an ion pair, a Lewis acid dopant being an organoborane for adjusting a state of the a spiro compound, and a polymer component comprising a polymer side group for forming the ion pair with the spiro compound. The organoborane is preferable a hydrate. It is remarked that BCF-water (Tris(pentafluorophenyl)borane water) is known as the Brønsted acid to efficiently oxidize spiro-OMeTAD molecules. In this context the organoborane forming a hydrate may favorably adjust a state of the spiro compound. Further preferably the organoborane, is a tris aryl borane, in which more preferably the aryl groups are fluorinated aryl groups. A particularly suitable Lewis acid is tris(pentafluorophenyl)borane. The hydrate may be formed with remaining moisture in the solution. The solution is preferably a hydrophobic, in particular substantially water free but may contain the hydrate water. The solution is a solution for forming the hole transport layer of the invention and in particular a hydrophobic solution. This layer may ensure a protection (of a perovskite layer) against water and oxygen and the solution is preferably adapted for this purpose, in particular as a hydrophobic solution.

The hole transport layer according to the invention, which particularly may be an organic and preferably a hydrophobic hole transport layer, comprises
- a spiro compound,
- a dopant adjusting a state of the spiro compound,
- a polymer component comprising a polymer side group, and
- ion pairs are formed of the spiro compound and the polymer side group,
the dopant comprising a Lewis acid being an organoborane, preferably a tris aryl borane, in which more preferably the aryl groups are fluorinated aryl groups. A particularly suitable Lewis acid is tris(pentafluorophenyl)borane.

The concept of the invention profits from utilizing a polymer side group of the polymer component, like the sulfonate groups in the polystyrene sulfonate of PEDOT:PSS to bond with a charge transfer agent or spiro compound like oxidized spiro-OMeTAD radicals for preventing a reaction with iodide from a perovskite layer placed under the hole transport layer like iodide post-oxidation. Simultaneously a state of the charge transfer agent or spiro compound is preferably adjusted so as to induce the sequential charge transfer for p-type doping. The concept of the invention profits from the possibility of providing or having a hydrophobic hole transport layer which can effectively restrain water/oxygen corrosion and immobilize the Pb²⁺ in a perovskite solar cell on the perovskite layer surface at the interface to the hole transport layer. With highly electrically conductive hole transport layers according to the invention and a fine-tuned energy level solar cells products become available with PCEs up to 25.31% (-0.1 cm²) and 21.96% (-29.0 cm²), and with excellent humidity, heat, and light stability, e.g. with 92.6%, 90.20% and 92.80% of an initial PCE remaining after storing, respectively, for 7000 h in air (40-70 %RH), 1000 h at 85 °C and 5000 h continuous illumination under maximum power point (MPP) tracking. In particular compared to a conventionally doped spiro compound like spiro-OMeTAD in a hole transport layer, the invention ensures that a polymer side group like the sulfonate group in case of polystyrolsulfonate as part of the polymer component can interact electrostatically with the spiro compound like spiro-OMeTAD⁺ to form stable ion pairs, which allows blocking iodide oxidation and preventing the crystallization of the spiro compound like spiro-OMeTAD at high temperature.

An aspect of the invention is a perovskite solar cell, comprising
- an electron transport layer,
- a perovskite layer on the electron transport layer,
- a hole transport layer according to the invention on the perovskite layer, and
- an electrode on the hole transport layer.

A solar module may comprise a plurality of perovskite solar cells on a substrate and connected with wiring, each of the perovskite solar cells is the perovskite solar cell according to the invention.

A method for preparing the solar cell according to the invention is a further aspect of the invention and comprises
depositing the solution according to the invention onto a perovskite layer formed on an electron transport layer,
subjecting the deposited solution to annealing for forming the hole transport layer according to the invention on the perovskite layer, and
forming a metal film on the hole transport layer.

The polymer component involved in the in the invention may comprise a pair of electrostatically interacting polymers formed of a conductive polymer, like Poly(3,4-ethylenedioxythiophene), and a polymer having the polymer side group, preferably having a sulfonate group as the side group and more preferably being polystyrene sulfonate. The spiro compound involved in the in the invention may be a 9,9'-spirobifluorene compound with tertiary amine groups, preferably spiro-OMeTAD. In accordance with preferences and exemplary hole transport layer of the invention is composed of spiro-OMeTAD, Poly(3,4-ethylenedioxythiophene) - polystyrene sulfonate (PEDOT:PSS) and Tris(pentafluorophenyl)borane (BCF). The solution of the invention may be formed with a concentration of PEDOT:PSS between 2 wt% and 50 wt%, in particular between 5 wt% and 40 wt%, preferably between 5 wt% and 15 wt%, more preferably between 8 wt% and 12 wt%.

Hole transport layer of the invention has desirable properties like high electrical conductivity, electrochemical stability, and catalytic activity for I₃⁻ ion reduction. As described above the hole transport layer, which particularly may be or be understood as an organic and preferably a hydrophobic hole transport layer, comprises the spiro compound, the dopant adjusting a state of the spiro compound, and the polymer component. In the hole transport layer preferable amounts of the spiro compound are between 2 wt% and 10 wt%, more preferably between 4.5 wt% and 7.5 wt%, preferable amounts of the dopant are between 0.1 wt% and 2 wt%, more preferably between 0.5 wt% and 0.9 wt%, preferable amounts of the polymer component are between 80 wt% and 97 wt%, more preferably between 90 wt% and 95 wt%. These amounts are indicated with respect to the total weight of the hole transport layer's components.

### BRIEF DESCRIPTION OF THE DRAWINGS

Features, advantages, and technical and industrial significance of exemplary embodiments of the invention will be described below with reference to the accompanying drawings in which
FIG. 1A schematically illustrates an example of a dopant used in the invention,
FIG. 1B schematically illustrates an example of a protonated spiro compound used in the invention,
FIG. 1C schematically illustrates an example of a polymer component used in the invention,
FIG. 1D schematically illustrates an example of the polymer component associated with the protonated spiro compound with an ion pair,
FIG. 2 shows current voltage measurements on solar cells,
FIG. 3 shows excitation spectra from hole transport layers,
FIG. 4 shows electron microscope images of hole transport layers,
FIG. 5A and 5B shows XRD measurements of hole transport layers,
FIG. 6 shows transient photo voltage measurements of hole transport layers,
FIG. 7 shows stability measurements of solar modules,
FIG. 8 shows TAS spectra of solar cells,
FIG. 9 shows a cross sectional view of a solar cell, and
FIG. 10 shows XPS measurements with a PbI₂ film on various templates.

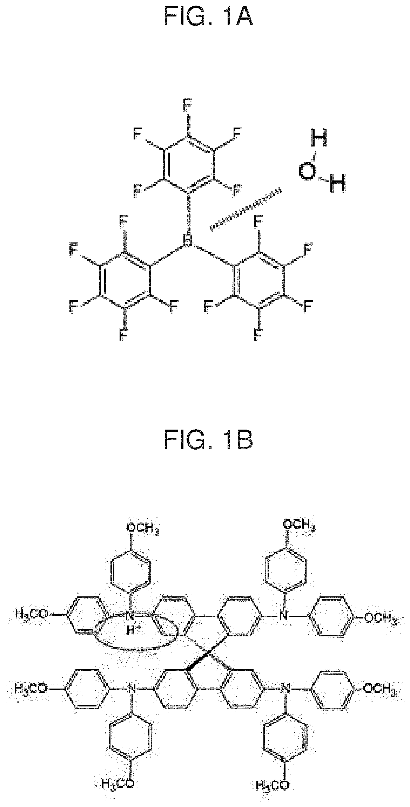

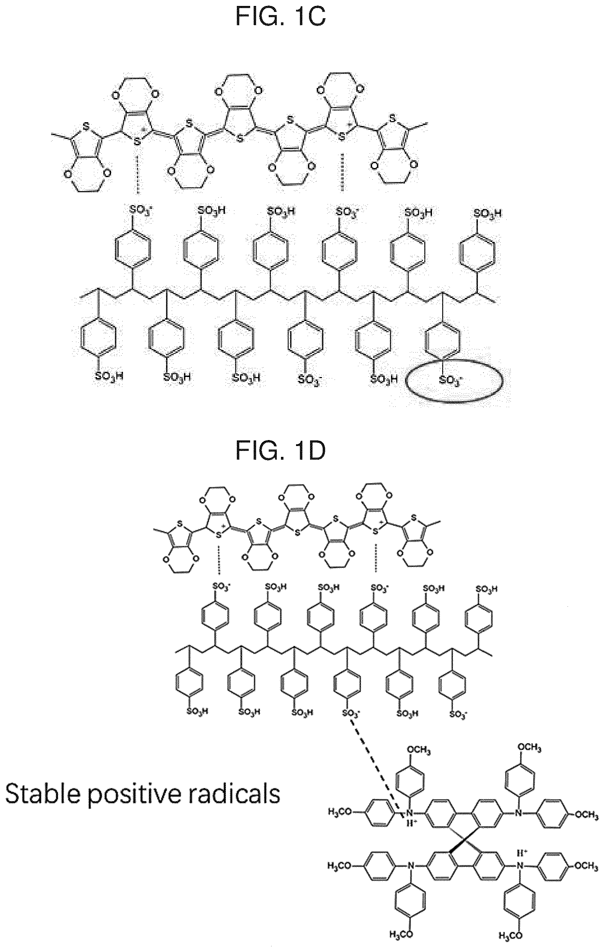

FIG. 1A illustrates a hydrate from BCF (Tris(pentafluorophenyl)borane) as formed in the presence of moisture. It is believed that this hydrate provides protonation and/or ionization of other compounds of the invention's hole transport layer as also schematically illustrated in Fig. 1B with a protonated spiro compound (spiro-OMeTAD, the protonation being encircled to highlight this aspect in the Figure). Thus, even in a hydrophobic environment spiro-OMeTAD is subjected to protonation. As illustrated in Fig. 1C polystyrene sulfonate electrostatically interacts with poly(3,4-ethylenedioxythiophene) as a conductive polymer and is subjected to ionization so as to expose a sulfonate ion (PEDOT:PSS, the ionization being encircled to highlight this aspect in the Figure). This sulfonate ion and the protonated tertiary amine group of spiro-OMeTAD form an ion pair as illustrated on the bottom of Fig. 1D.

### DETAILED DESCRIPTION AND EXAMPLES

### Materials

The materials and measurement equipment were used as follows.

| **Material** | **name, grade** | **supplier** |
|---|---|---|
| lead(ii) iodide | (PbI2; 99.99%) | purchased from TCI, |
| formamidine iodide | (FAI; 99.99%) | Greatcell Solar |
| methylammonium chloride | (MACl; 99.99%) | |
| tin(ii) chloride dihydrate | (SnCl2·2H2O; 98%) | Acros |
| 2,2',7,7'tetra-kis[N,N-di(4-methoxyphenyl)amino]-9,9'-spirobifluorene | (spiro-OMeTAD; > 99%) | Xi'an Polymer Light Technology |
| PEDOT:PSS | CLEVIO HTL Solar 3 | |
| tris (pentafluorophenyl) borane | (LAD; > 99%) | Aladdin |
| titanium(iv) chloride | (TiCl4; 99%) | |
| hydrochloric acid | (HCl; 37 wt% in H2O) | |
| 4-tert-butylpyridine | (4-tert-Butylpyridine, tBP, >98%) | Sigma-Aldrich |
| bis(trifluoromethane)sulfonimide lithium salt | (Li-TFSI; 99.95%) | |
| bis(trifluoromethane)sulfonimide cobalt(III) salt | FK 209 Co(III) TFSI | |
| Acetonitrile | (ACN; 99.8%) | |
| toluene | (TL) | |
| chlorobenzene | (CB; 99.8%) | |
| N, N-dimethylformamide | (DMF; 99.8%) | |
| dimethyl sulfoxide | (DMSO; 99.9%) | |
| isopropyl alcohol (IPA) | | |
| pre-patterned FTO glass (12-13 Ohm/square) | | Asahi |
| condensed-titanium dioxide | (c-TiO_{2,} pyrolysis from Titanium(IV) isopropoxide, >99%) | Sigma-Aldrich |
| condensed-tin dioxide | (c-SnO₂, 15% in H₂O colloidal dispersion) | Alfa |
| Si substrate | | SVM, US |
| measurement / related Fig. | equipment/settings | |
| energy level | Ultraviolet photoelectron spectroscopy (UPS) spectra with a Kratos AXIS ULTRA DALD with a He Iα photon source (hv = 21.22 eV) and 10 V bias voltage | |
| current voltage level / Fig. 2 | measured under an AM 1.5G simulated light source connected to a source meter (Keithley 2400), calibrated by an NREL-certified KG5 filtered Si reference diode | |
| responsiveness with PL spectra / Fig. 3 | FLS980, Edinburgh Instruments Ltd., UK | |
| c-AFM | Oxford Instruments, Jupiter XR, US | |
| AFM | Agilent 5500 AFM instrument | |
| SEM, Fig. 4 | HITACHI SU8010, Japan | |
| XRD / Fig. 5A, 5B | Japan, Rigaku, SmartLab SE | |
| transient photo voltage (TPV) / Fig. 6 | open circuit condition | |
| TAS / Fig. 8 | SOL-F-K-HP-T in 800 nm | |
| XPS / Fig. 10 | Axis Ultra DLD Kratos AXIS SUPRA | |

### Comparative solution

73.5 mg spiro-OMeTAD, 25 µL tBP, 17 µL Li□TFSI (520 mg in 1 mL acetonitrile), 8 µL FK 209 Co(III) TFSI (360 mg in 1 mL acetonitrile) were dissolved in 1 ml CB and stirred 12 h.

### Exemplary solution

16 mg spiro-OMeTAD, 2 mg LAD and 250 µL PEDOT:PSS were added in TL and stirred 2 h.

### Template for applying a perovskite layer

Patterned FTO substrate glass was washed in an ultrasonic bath with detergent (5% Hellmanex^{®} water; from Hellma GmbH & Co. KG: D-79379 Müllheim, Germany), deionized water, acetone, and isopropanol, respectively, in sequence for 30 min. The cleaned pre-patterned FTO glass was treated with UV ozone for 15 min to improve surface wettability. Thin layers of TiO2 (about 18 nm c-TiO2) and SnO2 (about 120 nm c-SnO2) were sequentially formed on the clean FTO substrate by chemical bath deposition (CBD) and the substrates were annealed on a hot plate at 190 °C for 60 minutes. After 15 min UV treatment, the substrates were taken into a nitrogen-filled glove box for the next steps.

### Template with perovskite layer

A 1.4 M perovskite precursor solution was prepared by dissolving 645.4 mg PbI2, 216.7 mg FAI, 11.1 mg MAI (methylammonium iodide), 33.1 mg MACl, and 11.8 mg CsCl in 1 mL of a mixed solution of DMF/ DMSO (8:1 v/v). The perovskite precursor solution was spin-coated onto the template for applying a perovskite layer at 1000 rpm for 10 s, accelerated to 5000 rpm after 10 s and maintained at this speed for 20 s. The product was subjected to a vacuum drying as shown in Gao et al., Preparation of flexible perovskite solar cells by a gas pump drying method on a plastic substrate, Journal of Materials Chemistry A 2016, 4 (10), 3704-3710 and after 20 seconds pumping in the vacuum device, a brown transparent perovskite film was formed on the substrate. The fresh perovskite layer was annealed at 100 °C for 1 h and then at 150 °C for 10 min.

### Exemplary hole transport layer on template with perovskite layer

The above exemplary solution was deposited on the template with perovskite layer by spin-coating at 2,000 rpm for 30 s. The resulting film was annealed on a hot plate at 110°C for 10 min.

### Exemplary solar cell

An ITO layer having a thickness of 100 nm was sputtered onto the exemplary hole transport layer formed on the template with perovskite layer and then an Au electrode was thermally evaporated onto this layer.

### Comparative hole transport layer on template with perovskite layer

The above comparative solution was deposited on the template with perovskite layer by spin-coating at 3,000 rpm for 30 s without annealing.

### Comparative solar cell

An ITO layer having a thickness of 100 nm was sputtered onto the comparative hole transport layer formed on the template with perovskite layer and then an Au electrode was thermally evaporated onto this layer.

### Exemplary and comparative solar module

The laser scribing system from Trotec, Trotec GmbH, 52525 Heinsberg, Germany, with a wavelength of 1064 nm and a power of 20 W and solar cell preparations described for exemplary and for the comparative solar cell were used to produce and exemplary and a comparative perovskite solar cell modules, each with a surface of 6.5 × 7.0 cm² and consisting of eight series-connected sub-cells, with specifications as follows:

| | |
|---|---|
| Preparation of patterned FTO substrate glass with P1 lines of 40 µm width | power - 60% laser power |
| | speed - 300 mm/s |
| | frequency - 65 kHz |
| | pulse width - 120 ns |
| Preparation of template with perovskite layer | Using the patterned FTO substrate glass with the P1 lines and preparing the above-described preparation of template with perovskite layer |
| Preparation of exemplary and comparative hole transport layer, respectively, on the template with perovskite layer | as described above |
| Depositing P2 lines of 150 µm width on the exemplary and comparative hole transport layer, respectively | power - 15% laser power |
| | speed - 1000 mm/s |
| | frequency - 65 kHz |
| | pulse width - 120 ns |
| Preparation of a 70 nm Au electrode | as described for the exemplary and the comparative solar cell above |
| Depositing P3 lines of 40 µm width on the Au electrode | power - 15% laser power |
| | speed - 1000 mm/s |
| | frequency - 65 kHz |
| | pulse width - 120 ns |
| | distance to P1 lines - around 270 µm |
| | geometric fill factor (GFF) - around 95.5%. |

### Energy level evaluation of the exemplary hole transport layer

An energy level was measured for the above exemplary hole transport layer and the energy level (eV) was comparable to the energy level reported in You et al., 2023 for a sample with the iodine blocking barrier investigated in this document.

### Current voltage curve level evaluation of solar cells

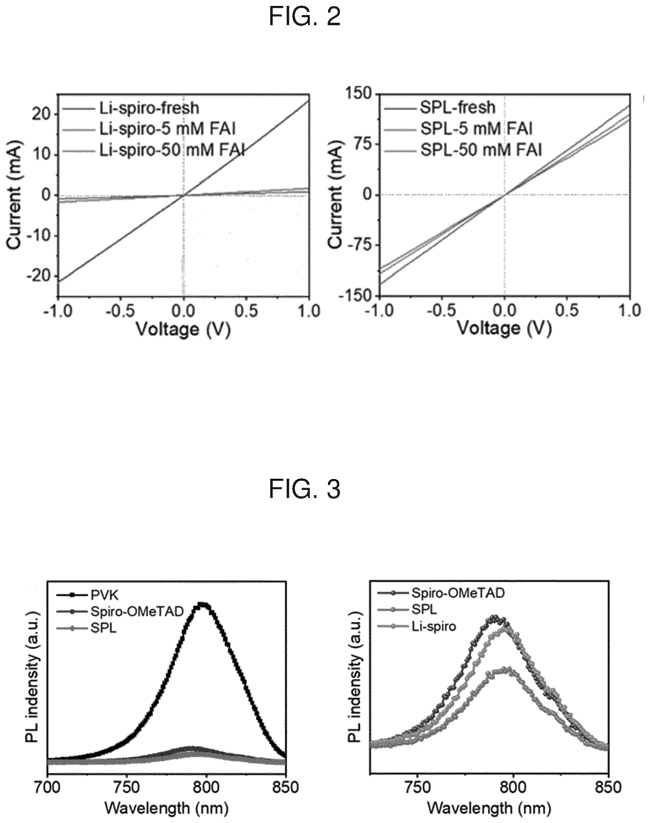

As described in Zhang et al., 2022 samples were prepared with a PEDOT:PSS-ITO layer coated with a hole transport layer and an Au electrode layer on top of the hole transport layer and subjected to a current voltage measurement before and after spin coating at 5000 rpm with FAI solutions of 5 mM or 50 mM FAI, respectively. The hole transport layer was prepared
- once in accordance with the above-described preparation of the exemplary hole transport layer to provide the measurement results shown in Fig. 2 on the left side with small slopes obtained with FAI solutions of 5 mM or 50 mM FAI, and
- once with the above-described preparation of the comparative hole transport layer and once hole to provide the measurement results shown in Fig. 2 on the right side which demonstrate stability against iodine invasion from FAI.

### Responsiveness evaluation of hole transport layers

Samples were prepared
- with templates of a PEDOT:PSS·ITO layer coated with perovskite layer formed in line with the above description for the 'Template with perovskite layer' and for the ITO layer sputtering and in line with a formation of a p-i-n solar cell (also called in inverted device), and
- with and without coating hole transport layers,
and subjected to the recording of steady state fluorescence spectra (PL spectra) spectra at an excitation wavelength of 470 nm which are shown in Fig. 3 with different intensity scales on the left and right sides of Fig. 3. For the samples the hole transport layer was
- once omitted to provide the spectral curve with the highest peak on the left side in Fig. 3,
   once added and prepared in accordance with the above-described preparation of the exemplary hole transport layer to provide the spectral curve with the lowest peak on the left and right sides in Fig. 3,
- once added and prepared in accordance with the above-described preparation of the exemplary hole transport layer except that BCF was omitted and to provide the spectral curve with the second lowest peak on the left side in Fig. 3 and with the highest peak on the right side in Fig. 3, and
- once added and prepared in accordance with the above-described preparation of the comparative hole transport layer to provide the spectral curve with the second lowest peak on the right side in Fig. 3.

The samples with a hole transport layer exhibit weaker PL signals than without it (i.e. with pristine perovskite), indicating effective charge transfer. In addition, exemplary preparation exhibits a weaker PL signal than the other two samples with a hole transport layer, indicating much more efficient hole extraction.

### Light aging evaluations of hole transport layers

Each of the above-described preparation of the exemplary hole transport layer and the above-described preparation of the comparative hole transport layer on their template was subjected to measurements before and after aging with LED soaking at 100mW/cm² at 85°C for 200 h (hours) and with results as follows:

| **layer** | **measurement** | **results** |
|---|---|---|
| exemplary | c-AFM, AFM and SEM imaging | average current of 0.8 nA before aging, 95% of which was preserved after aging in c-AFM, smooth aged surface in SEM, and drastically aged/changed topography in AFM imaging |
| comparative | c-AFM, AFM and SEM imaging | average current of 0.217 nA before aging and 0.056 nA after aging in c-AFM, rough aged surface in SEM, and constant topography in AFM imaging |
| exemplary | difference of contact potential with a Kelvin probe force microscope between tip and surface | 592 mV before and essentially maintained after aging |
| comparative | difference of contact potential with a Kelvin probe force microscope between tip and surface | 614 mV before and 392 mV with observed PbI₂ aggregates after aging |
| exemplary | electron microscopic imaging | Fig. 4 upper left image before and lower right image after aging |
| comparative | electron microscopic imaging | Fig. 4 upper right image before and lower left image with PbI₂ aggregates after aging |

### Further light aging evaluations of hole transport layers

Each of the above-described preparation of the exemplary hole transport layer and the above-described preparation of the comparative hole transport layer on their template was subjected to measurements before and after aging with LED soaking at 100mW/cm² with periods and conditions (heat, humidity) as follows:

| **hole transport layer** | **aging** | **measurement** | **result** |
|---|---|---|---|
| exemplary | under N₂ atmosphere for periods indicated in Fig. 5A | XRD | Fig. 5A left side |
| comparative | under N₂ atmosphere for periods indicated in Fig. 5A | XRD | Fig. 5A right side, peak of PbI₂ at 12.6° occurring after 1000h |
| exemplary | under an atmosphere with 50±5% RH at 30±5°C for periods indicated in Fig. 5B | XRD | Fig. 5B left side |
| Comparative | under an atmosphere with 50±5% RH at 30±5°C for periods indicated in Fig. 5B | XRD | Fig. 5B right side, peak of δ perovskite at 11.8° occurring after 200h decomposition after 400h eliminates other peaks |

In a visual color observation and under each of the above aging conditions a significant color change of the comparative hole transport layer compared to the exemplary hole transport layer was confirmed.

### Contact angle evaluation of hole transport layers

Samples were prepared as indicated above for the current voltage curve level evaluation and subjected to a contact angle measurement in accordance with ISO 19403. with a hole layer formation in accordance with the above-described preparation of the exemplary hole transport layer the contact angle was 98.41° and with the above-described preparation of the comparative hole transport layer the contact angle was 78.74° indication worse hydrophobicity and related stability.

### Charge carrier recombination in solar modules

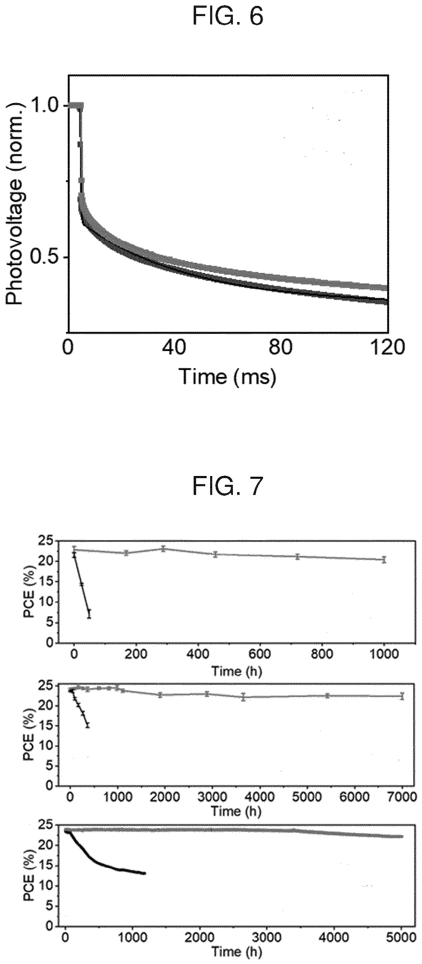

With the above-described exemplary and comparative solar modules the transient photo voltage (TPV) curves shown in Fig. 6 were recorded under open circuit conditions, the lower curve being that from the comparative and the upper curve being that from the exemplary solar module. Since the transient photovoltage (TPV) indicates that the carrier recombination lifetime (after an excitation examined with the spectra in Fig. 3) a retarded charge carrier recombination is observed in the exemplary compared to the comparative solar module, which is beneficial for the charge carrier collection.

### Long term stability evaluation of solar modules

The above-described exemplary and comparative solar modules were subjected to three stability tests according to International Summit on Organic Photovoltaic Stability (ISOS) protocols and conversion efficiency (PCE) measurements at various time points as shown in Fig. 7 which shows rapid loss of PCE for the comparative and stable PCE for the exemplary solar module in each of the tests. Specifically, the following tests and conditions were used:

| **test** | **encapsulation of the module** | **Light** | **temperature (°C)** | **atmosphere, humidity** |
|---|---|---|---|---|
| ISOS-L-2 | yes | dark storage | 85 | air, 40-70% RH |
| ISOS-D-1 | no | dark storage | 25-35 | air, 40-70% RH |
| ISOS-L-1 | yes | sun without UV filter | 50 | air, 40-70% RH |

### Further exemplary and comparative solar cells

The above-described preparation of the exemplary solar cell was varied by forming the hole transport layer with a solution which differs from the above-described exemplary solution in that concentrations of PEDOT:PSS of 5 wt%, 10 wt%, 20 wt%, and 40 wt%, respectively are adjusted and measured under an AM 1.5G simulated light source connected to a source meter (Keithley 2400), calibrated by an NREL-certified KG5 filtered Si reference diode. Further exemplary solar cells were obtained in this manner. The above-described comparative solar cell was varied by forming the hole transport layer with a solution which differs from the above-described comparative solution in that concentrations of PEDOT:PSS of 5 wt%, 10 wt%, 20 wt%, and 40 wt%, respectively are adjusted. Further comparative solar cells were obtained in this manner. Using the concentrations of PEDOT:PSS of 10 wt% champion cells, namely the further exemplary cell - SPL - and the further comparative cell - Li-spiro - were obtained with measurement values as follows:

| | *V*_{OC} (V) at 100 mW/cm² light intensity | ideality factor of a linear *V*_{OC} regression over 11 light intensities between 5 mW/cm² and 100 mW/cm² | *J*_{SC} (mA/cm²) | FF (%) | PCE (%) |
|---|---|---|---|---|---|
| Li-spiro | 1.146 | 1.89 | 26.26 | 82.50 | 24.83 |
| SPL | 1.154 | 1.64 | 26.31 | 83.40 | 25.31 |

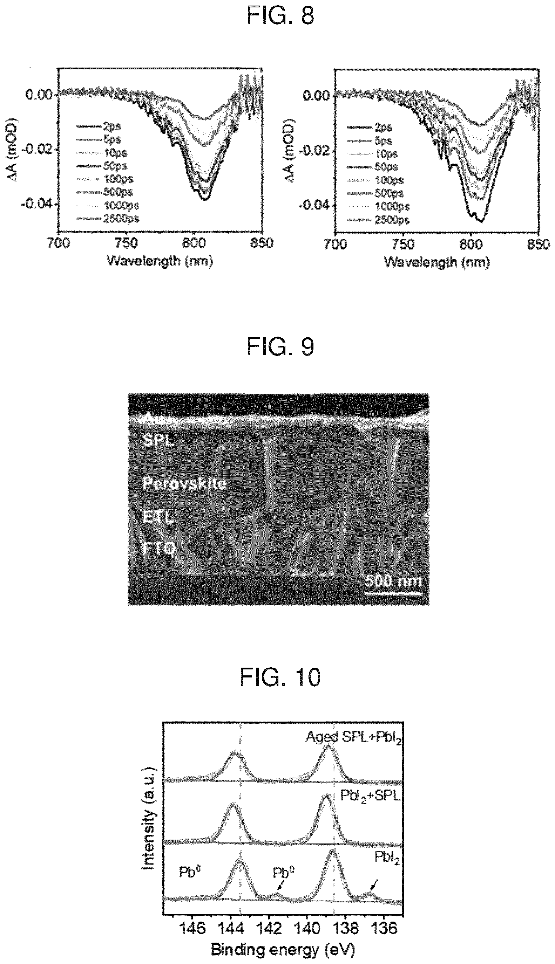

TAS spectra as shown in Fig. 8 were recorded from the cells Li-spiro (on the left side in Fig. 8) and SPL (on the right side in Fig. 8) with delay times as indicated in Fig. 8. The deepness of peaks occurring in the TAS spectra decreases in the order of the length of the delay times so that the deepest peak in the spectra for each of Li-spiro and SPL is that measured with the shortest delay time. A cross-sectional microscopic image of SPL is shown in Fig. 9.

### Evaluation of metallic lead generation via a hole transport layer

Three samples were prepared by depositing an PbI₂ film onto a respective template formed based on an Si substrate and subjected to an XPS measurement to obtain the spectra of Fig. 10. For the template a coating on the Si substrate (before PbI₂ film deposition) was
- once omitted to provide sample "PbI₂" with the lower spectral curve shown in Fig. 10,
- once added and prepared in accordance with the above-described preparation of the exemplary hole transport layer to provide sample "PbI₂+SPL" and the spectral curve in the middle of Fig. 10 and after aging at 85°C for 200h , sample "Aged PbI₂+SPL" and the upper spectral curve in Fig. 10.

In Fig. 10 sample "PbI₂" during XPS testing shows distinct metallic lead peaks (136.77 eV and 141.66 eV) near the Pb²⁺ peaks (138.6 eV and 143.5 eV) due to the decomposition of lead iodide which simulates a perovskite decomposition. In the XPS pattern for sample "PbI₂+SPL", only the Pb²⁺ peaks shift to higher binding energy, indicating that the interaction between the exemplary hole transport layer and Pb²⁺ inhibits the production of metallic lead and related decomposition. Even after aging at 85°C for 200 h this inhibition is observed.

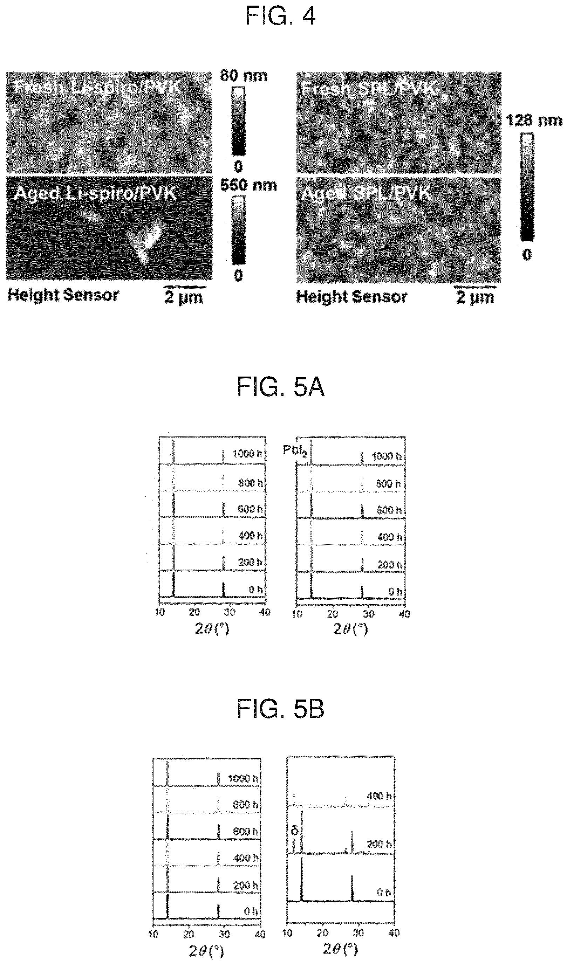

In view of the above the invention serves for the preparation of a solar cell and/or a solar module and/or its hole transport layer which preferably shows/show at least one of the following beneficial properties:
- maintaining more than 90% of initial conductivity (reflected by the change of a slope of current voltage curves as shown in Fig. 2) after the aging treatment described for Fig. 2,
- the absence of aggregates with a diameter of more than 0.5 µm on a hole transport layer surface after the aging treatment described for Fig. 4,
- the absence of additional peaks in an XRD measurement and aging process of 200h or 400h as described for Fig. 5B and/or additional peaks in an XPS measurement and aging process described for Fig. 10,
- a contact angle on a hole transport layer surface measured as described above of more than 85°, more preferably more than 90°, and
- maintaining more than 80%, more preferably more than 90% of an initial PCE after 5000h of the aging treatment with illumination described for Fig. 7.

Although the present disclosure refers to specific exemplary embodiments, modifications may be provided to these examples without departing from the general scope of the invention as defined by the claims. In particular, individual characteristics of the different illustrated/mentioned embodiments may be combined in additional embodiments. Therefore, the description and the drawing should be considered in an illustrative rather than in a restrictive sense.

## Claims

1. A hole transport layer, for a perovskite solar cell, the transport layer comprising
- a spiro compound,
- a dopant adjusting a state of the spiro compound,
- a polymer component comprising a polymer side group, and
- ion pairs formed of the spiro compound and the polymer side group,
the dopant comprising a Lewis acid being an organoborane.

2. The hole transport layer according to claim 1, wherein the organoborane is a tris aryl borane.

3. The hole transport layer according to claim 2, wherein the aryl groups of the organoborane are fluorinated aryl groups.

4. The hole transport layer according to claim 3, wherein the Lewis acid is tris(pentafluorophenyl)borane.

5. The hole transport layer according to of claims 1 to 4, wherein the polymer component comprises a pair of electrostatically interacting polymers formed of a polymer having the polymer side group and a conductive polymer.

6. The hole transport layer according to any of claims 1 to 5, wherein the polymer side group is a sulfonate group.

7. The hole transport layer according to claim 6, wherein the polymer component comprises polystyrene sulfonate.

8. The hole transport layer according to any of claims 1 or 7, wherein the spiro compound is a 9,9'-spirobifluorene compound with tertiary amine groups.

9. A perovskite solar cell, comprising
- an electron transport layer,
- a perovskite layer on the electron transport layer,
- a hole transport layer according to any of claims 1 to 8 on the perovskite layer, and
- an electrode on the hole transport layer.

10. A solar module, comprising a plurality of perovskite solar cells on a substrate and connected with wiring, wherein
each of the perovskite solar cells is a perovskite solar cell according to claim 9.

11. A use of an organoborane as a Lewis acid dopant for adjusting a state of a spiro compound in an hole transport layer, which is a layer for a perovskite solar cell and comprises the spiro compound, a polymer component comprising a polymer side group, and ion pairs formed of the spiro compound and the polymer side group.

12. A solution for forming the hole transport layer according to any of claims 1 to 8, the solution comprising an organic solvent, a spiro compound for forming an ion pair, a Lewis acid dopant being an organoborane for adjusting a state of the a spiro compound, and a polymer component comprising a polymer side group for forming the ion pair with the spiro compound.

13. The solution according to claim 12, wherein the organoborane is a hydrate.

14. The solution according to claim 12 or 13 being a hydrophobic solution.

15. A method for preparing the solar cell according to claim 9, comprising
depositing the solution according to claim 12, 13 or 14 onto a perovskite layer formed on an electron transport layer,
subjecting the deposited solution to annealing for forming the hole transport layer according to any one of claims 1 to 8 on the perovskite layer, and
forming a metal film on the hole transport layer.

## Amended claims

### Amended claims in accordance with Rule 137(2) EPC.

1. A use of an organoborane forming a hydrate for adjusting a state of a spiro compound in a hole transport layer, which is a layer for a perovskite solar cell and comprises the spiro compound, a polymer component comprising a polymer side group, and ion pairs formed of the spiro compound in said state and the polymer side group.

2. A hole transport layer, for a perovskite solar cell, the transport layer comprising
- a spiro compound in a state of the spiro compound adjusted in accordance with the use of claim 1,
- a polymer component comprising a polymer side group,
- ion pairs formed of the spiro compound in said state and the polymer side group, and
- the organoborane.

3. The hole transport layer according to claim 2, wherein the organoborane is a tris aryl borane.

4. The hole transport layer according to claim 3, wherein the aryl groups of the organoborane are fluorinated aryl groups.

5. The hole transport layer according to claim 4, wherein the organoborane is tris(pentafluorophenyl)borane.

6. The hole transport layer according to any one of claims 2 to 5, wherein the polymer component comprises a pair of electrostatically interacting polymers formed of a polymer having the polymer side group and a conductive polymer.

7. The hole transport layer according to any one of claims 2 to 6, wherein the polymer side group is a sulfonate group.

8. The hole transport layer according to claim 7, wherein the polymer component comprises polystyrene sulfonate.

9. The hole transport layer according to any one of claims 2 or 8, wherein the spiro compound is a 9,9'-spirobifluorene compound with tertiary amine groups.

10. A perovskite solar cell, comprising
- an electron transport layer,
- a perovskite layer on the electron transport layer,
- a hole transport layer according to any one of claims 2 to 9 on the perovskite layer, and
- an electrode on the hole transport layer.

11. A solar module, comprising a plurality of perovskite solar cells on a substrate and connected with wiring, wherein
each of the perovskite solar cells is a perovskite solar cell according to claim 10.

12. A solution for forming the hole transport layer according to any one of claims 2 to 9, the solution comprising an organic solvent, a spiro compound for forming an ion pair, a dopant being an organoborane hydrate for adjusting a state of the a spiro compound, and a polymer component comprising a polymer side group for forming the ion pair with the spiro compound.

13. The solution according to claim 12 being a hydrophobic solution.

14. A method for preparing the solar cell according to claim 10, comprising depositing the solution according to claim 12 or 13onto a perovskite layer formed on an electron transport layer,
subjecting the deposited solution to annealing for forming the hole transport layer according to any one of claims 2 to 9 on the perovskite layer, and
forming a metal film on the hole transport layer.
